# NEUE EUROPÄISCHE PATENTSCHRIFT

(11) **EP 1 655 762 B2**
(45) Veröffentlichungstag und Bekanntmachung des Hinweises auf die Entscheidung über den Einspruch: **03.08.2011**
(45) Hinweis auf die Patenterteilung: 26.09.2007
(21) Anmeldenummer: 05007131.5
(22) Anmeldetag: 31.03.2005
(51) Int. Cl.: H01J 37/34

(54) **Katodenanordnung zur Zerstäubung eines drehbaren Targetrohres**
Cathode assembly for sputtering a rotatable tubular target
Dispositif de cathode pour la pulvérisation d'une cible tubulaire rotative

(30) Priorität: 05.11.2004 US 983179
(43) Veröffentlichungstag der Anmeldung: 10.05.2006
(73) Patentinhaber: Applied Materials GmbH & Co. KG, 63755 Alzenau (DE); Applied Materials, Inc., Santa Clara, CA 95054-3299 (US)
(72) Erfinder: Newcomb, Richard, Johnstown Colorado 80504 (US); Trube, Scott, Loveland Colorado 80537 (US); Riso, Tom, Elizabeth Colorado 80107 (US); Kawakami, Ken, Fort Collins Colorado 80504 (US); Marquardt, Dietmar, 63526 Erlensee (DE); Sauer, Andreas, 63762 Grossostheim (DE)
(74) Vertreter: Zimmermann & Partner

(56) Entgegenhaltungen:
- WO-A1-92/02659
- DE-A1- 10 312 631
- US-A- 5 445 721
- US-A- 5 539 272
- US-A- 5 571 393
- US-A1- 2004 149 576
- US-B1- 6 488 824

## Beschreibung

Die Erfindung betrifft eine Katodenanordnung zur Zerstäubung eines Targetrohres nach dem Oberbegriff des Patentanspruchs 1.

In der Vakuumbeschichtungstechnik kommen zunehmend häufiger rotierende Beschichtungskatoden zum Einsatz. Hierbei handelt es sich in der Regel um ein um die Längsachse drehbares Rohr mit einem im Innern feststehenden Magnetsystem. Ein Vorteil dieser Rotationskatoden gegenüber planaren Katoden ist eine wesentlich bessere Ausnutzung des Targetmaterials und somit eine höhere Standzeit.

Diese Rohrkatoden unterscheiden sich im wesentlichen in zwei Bauprinzipen. Die Erklärung der beiden Prinzipien erfolgt an den Beispielen horizontaler Beschichtungsanlagen.

Beim ersten Prinzip ist die komplette Antriebseinheit inklusive der Medienzuführung am Deckel der Beschichtungskammer in Form von sogenannten Endblöcken oder Endköpfen an jeweils einem Rohrende montiert. Zum Targetwechsel wird die gesamte Einheilt inklusive Deckel von der Anlage abgenommen. Ausserhalb der Anlage wird nun auf einem speziellen Arbeitsgestell der Targetwechsel vorgenommen oder die komplette Einheit ausgetauscht.

Beim zweiten Prinzip ist die Antriebseinheit inklusive der Medienzuführung an einer seitlichen Kammerwand montiert. Drehbewegungen und Medien werden somit von der Seite her in die Prozesskammer eingeführt. Bis zu einer gewissen Rohrlänge kann dies eine frei auskragende ("cantilevered") Konstruktion sein. Bei längeren Rohren wird eine zusätzliche Abstützung am anderen Rohrende benötigt. Zum Targetwechsel wird nun das Targetrohr inklusive des im Innern befindlichen Magnetsystems von der Antriebseinheit abgeflanscht und aus der Kammer gehoben. Danach kann entweder die komplette Target-Magneteinheit getauscht oder weiter zerlegt und nur das eigentliche Targetrohr ausgetauscht werden.

Das Hauptziel ist dabei immer, einen Targetwechsel in möglichst kurzer Zeit durchzuführen, um eine möglichst kurze Stillstandszeit der Anlage zu erhalten.

Bei den auskragenden Katoden kommen noch weitere negative Punkte hinzu: Konstruktions- und betriebsbedingt entstehen mindestens an der antriebsseitigen Verbindungsstelle sehr hohe Kräfte. Weiterhin muß ein exakter Rotationslauf durch konstante Achslage gegeben sein, da bereits kleinere Abweichungen bei einer Targetlänge von vier Metern enorme negative Auswirkungen haben.

Stand der Technik sind hierbei meist einfache Flanschlösungen, die am äusseren Durchmesser mit mehreren Schrauben verbunden sind. Dies ist zwar eine mechanisch stabile Verbindung, hat aber den Nachteil, dass zur Demontage alle Schrauben einzeln gelöst werden müssen, womit ein hoher Platzbedarf und ein ernormer Zeitaufwand verbunden sind.

Des weiteren sind verschiedene Lösungen bekannt, bei denen die Verbindung über eine Kombination aus überwurfmuttern mit verschiedenen Geometrien an der Targetaussenfläche hergestellt ist.

Als weitere Schwierigkeit bei der Gestaltung einer Verbindung sei noch erwähnt, dass es zwei verschiedene Prinzipien von Targetrohren gibt.

Beim ersten Prinzip handelt es sich um Targets, die aus einem mechanisch stabilen, vakuumdichten und bearbeitbaren dickwandigen Rohr hergestellt werden. Hierbei sind der Gestaltung von Dicht- und Befestigungsgeometrien keine engen Grenzen gesetzt.

Beim zweiten Prinzip handelt es sich verfahrensbedingt um ein dünnwandiges, aber doch vakuumdichtes und mechanisch stabiles Trägerrohr, auf das wiederum das eigentliche Targetmaterial, z.B. Si, Zn, SiAl und alle weiteren, mechanisch nicht stabilen Materalien in verschiedener Weise aufgebracht sind.

Eine der Aufgaben war es daher, eine Verbindung zwischen Antrieb und Targetrohr zu erhalten, die einerseits unabhängig vom Aufbau des Targetrohres ist, andererseits aber die Target-Magnetsystem-Einheit mechanisch und vakuumtechnisch zuverlässig korreliert, und ferner einen schnellen Targetwechsel erlaubt. Gleichzeitig soll ein schnelles Zerlegen der TargetMagnetsystem-Einheit möglich sein. Auch sollte das Target- bzw. Trägerrohr einfach und kostengünstig herstellbar sein, da es sich hierbei um Verschleissteile handelt.

Der Stand der Technik wird nachfolgend anhand einiger Druckschriften näher erläutert:

Die US 4 356 073 offenbart eine Zerstäubungs- und Beschichtungsvorrichtung für ebene Substrate mit einer zylindrischen Katode und einem in dieser achsparallel untergebrachten Magnetsystem. Die Katode ist einseitig offen und dort mit einem Handgriff versehen, durch den abschnittsweise neue oder andere Flächenteile durch Drehung der Katode in den Wirkungsbereich des rennbahnförmigen ("race track") Magnetfeldes gebracht werden können, sei es zum Ausgleich des Abtrags, sei es zur Veränderung des Beschichtungsmaterials. Das gleichfalls durch einen Hebel in der Winkelstellung veränderbare Magnetsystem stützt sich über aufgesetzte Polschuhe - reibungsbehaftet - auf der Innenfläche des Targetrohres ab. Kühlwasser wird durch den rohrförmigen Magnetträger zugeführt und fliesst aus der öfffnung des Targetrohres ins Freie ab. Die Montage und der verschleissbedingte Austausch des Targetrohres ist nur durch eine kreisförmige öffnung entsprechend grösseren Querschnitts, durch Abschrauben eines Spannrings und eines Lagerrings möglich, wobei es schwierig sein dürfte, den gegenüber liegenden zentrischen Lagerzapfen des dort verschlossenen Targetrohres in sein ortfestes Lager einzufädeln, ohne die gesamte Anlage öffnen zu müssen.

Durch die US 4 417 968 ist ein rotationssymmetrisches Katodensystem zur Magnetronbeschichtung von rotierendem Massengut in einer zylindrischen Kammer bekannt, in der konzentrisch ein ortfestes Targetrohr und in diesem ein drehbares vielpoliges Magnetsystem angeordnet sind. In radial und tangential äquidistanten Abständen sind achsparallel zahlreiche weitere Magnetronkatoden mit umgekehrtem Bauprinzip angeordnet, d.h. innerhalb von durch Antriebe drehbaren Targetrohren sind stationäre, auf das Zentrum ausgerichtete Magnetsysteme angeordnet. In dem etwa ringförmigen Zwischenraum zwischen dem zentralen Targetrohr und den peripheren Targetrohren sind zahlreiche stabförmige Substrathalter angeordnet, die durch ein Planetengetriebe synchron angetrieben sind. Zum Wechsel aller Targetrohre muß - schon wegen deren beidendigen Lagerungen - der kreisförmige Kammerdeckel mit den Substrathaltern abgebaut werden, und auch die Montage und der Wechsel der Targetrohre gestalten sich wegen der Tiefe der Kammer und der Notwendigkeit der Lösung der zahlreichen Verschraubungen am jenseitigen Ende der Kammer zweitaufwendig und schwierig. Auch die Kühlsysteme sind dabei zu lösen und zu öffnen und wieder zu verschliessen.

Durch die US 4 422 916, die eine "Continuation-in-part" der US 4 356 073 ist, ist ab Figur 9 ein kontinuierlich arbeitendes Katodenzerstäubungssystem zum Beschichten flacher Substrate bekannt. An der Decke einer etwa quaderförmigen Vakuumkammer sind beidendig ein rotierbares Targetrohr und ein darin stationär gelagertes Magnetsystem angeordnet. Zwei Hohlwellen einer ortfesten Kammer mit dem Magnetsystem sind über Lagerböcke mit Kühlanschlüssen gehalten. Auf den besagten Hohlwellen ist drehbar mittels zweier Endwände und darin angeordneten Lagerbuchsen das drehbare Targetrohr gelagert, das durch ein konzentrisches Zahnrad, ein exzentrisches Ritzel mit einer achsparallen Welle und einen externen, auf der Kammer angeordneten Elektromotor über eine Kette angetrieben wird. Auch in diesen Falle gestalten sich eine Montage und ein Wechsel des Targetrohres zeitaufwendig und schwierig, weil zu diesen Zwecken das Magnetsystem nach Abbau eines Kammerdeckels mit ausgebaut werden muss.

Durch die US 5 437 778 und die US 5 529 674 sind rohrförmige, nicht drehbare Targets bekannt, durch die die Substrate entweder axial oder durch Schlitze quer zur Achse hindurch geführt werden können. Weiterhin sind Varianten beschrieben, bei denen bandförmige Substrate aussen über die Schlitze hinweg geführt werden. Weiterhin sind plattenförmige ("planare") Targets mit Längsbohrungen und achsparalellen Schlitzen beschrieben, über die bandförmige Substrate hinweg geführt werden können. Sowohl die Targets als auch deren Tragelemente sind als nichtdrehbar gezeigt, weil eine Drehung durch radiale Verbindungselemente für externe Anschlüsse verhindert würde. Für die Verbindung der Tragelemente und der Targets - soweit rotationssymmetrisch - sind Spannzangen offenbart, die aus gelenkig verbundenen Ringhälften mit inneren Kegelflächen und je einem Gelenk und einer Spannschraube bestehen, deren Achse senkrecht zur Rohrachse verläuft. Soweit Magnetsysteme für den Einschluss von Plasma offenbart sind (Figuren 9 und 20), befinden sich diese ausserhalb des Tragetrohres. Mit solchen Systemen befasst sich die Erfindung nicht.

Durch die WO 00/00766 ist es bekannt, am Ende einer rohrförmigen Tragwelle für ein austauschbares rohrförmiges Target oder eine TargetRohr-Kombination einen radialen Ringflansch mit einer Stufe und zwei Dichtungsnuten anzuordnen, auf die das Ende des Targets wasser- und vakuumdicht aufgeschoben werden kann. Der Ringflansch der Tragwelle und ein weiterer Ringflansch am Ende des Tragetrohres sind dabei durch eine lösbare Kupplungsanordnung verbunden, die aus zwei halbkreisförmigen Ringhälften besteht, die gegen die Ringflansche durch mindestens eine Schraube verspannbar sind, deren Achse rechtwinklig zur Rotationsachse verläuft. Dabei besitzen die Ringhälften mindestens je eine HalbKegelfläche, die komplementär zu einer Kegelfläche am Ringflansch der Tragwelle ausgebildet ist. Eine solche Kupplungsanordnung bedingt jedoch erhebliche Freiräume zum Ansetzen von Werkzeugen und für die Schwenk- oder Abnahmebewegungen der Ringhälften selbst, und es treten beim Verspannen der Ringhälften erhebliche tangentiale, Kraft verzehrende und Verschleiss verursachende Gleitbewegungen auf.

Durch die US 5 096 562 ist es bekannt, die beiden Enden eines rohrförmigen Targets mit zwei Tragwellen zu verbinden, die an ihren targetseitigen Enden je einen Ringflansch aufweisen. über die Art der Verbindung oder ihre Lösbarkeit ist jedoch nichts ausgesagt. Für die Lagerung der Tragwellen sind im Innern der Vakuumkammer - jeweils isoliert - Lagerböcke angeordnet, von denen der eine zur Stromübertragung und der andere zur Zu- und Abfuhr von Kühlwasser ausgebildet ist. Die vakuum- und wasserdichte Lagerung bedingt jedoch ein komplexes System von Rotationsdichtungen, deren Trennung das Auswechseln des Target erschwert.

Durch die US 5 591 314 und die entsprechende WO 97/15697 ist es weiterhin bekannt, das Ende einer Tragwelle für ein rohrförmiges Target mit einem Ringflansch zu versehen, dessen dem Target zugekehrte Seite eine Stufe mit einer radialen Ringfläche und einer Dichtungsnut mit Ringdichtung aufweist. Die Stufe dient jedoch nur zum planparallelen Ausrichten von Tragwelle und Target und nicht zum Zentrieren. Der Versuch einer Zentrierung wird vielmehr durch einen Spannring und eine Gewindeverbindung gemacht, die sich auf der Innenseite des Spannrings und der Aussenseite des Targetendes befindet. Vorzugsweise soll die Gewindeverbindung durch zwei schraubenförmig gewendelte Abschnitte eines Stahldrahtes erfolgen. Auch eine solche Kupplungsanordnung bedingt erhebliche Freiräume zum Ansetzen von Werkzeugen und für die Abnahmebewegung des Spannringes selbst, und es treten beim Verspannen erhebliche tangentiale, Kraft verzehrende und Verschleiss verursachende Gleitbewegungen auf, worauf auch besonders hingewiesen wird.

Durch die US 6 375 815 B1 ist es bekannt, Tragwellen von drehbaren rohrförmigen Targets mit je einem Ringflansch zu versehen und die Verbindung mit den Targets wiederum durch halbringförmige Kupplungselemente durchzuführen, die einerseits hinterschnittene Ringflansche der Targets und andererseits Ringe auf den Tragwellen übergreifen, und zwar gleichfalls mittels hinterschnittener Gewindeverbindungen, die gleichzeitig eine axiale und eine radiale Verspannung herbeiführen. Solche Gewindeverbindungen sind nur mit grossem Bearbeitungsaufwand herzustellen. Eine solche Kupplungsanordnung bedingt jedoch erhebliche Freiräume zum Ansetzen von Werkzeugen und für die Schwenk- oder Abnahmebewegungen der Ringhälften selbst, und es treten beim Verspannen der Ringhälften erhebliche tangentiale, Kraft verzehrende und Verschleiss verursachende Gleitbewegungen auf.

Durch die DE 10312631 A1 ist ein Magnetron mit einer zylindrischen Targetkonstruktion bekannt, welche in einer Vakuumkammer drehbar gelagert ist. Das Targettragrohr wird über eine Gegenplatte mit der Antriebswelle verbunden. Weitere Details über die Verbindung werden nicht offenbart.

Der Erfindung liegt demgegenüber die Aufgabe zugrunde, eine Katodenanordnung der eingangs beschriebenen Gattung dahingehend zu verbessern, dass gleichzeitig eine hohe und hoch belastbare Koaxialität von Tragwelle(n) und Targetrohren, eine zuverlässige Abdichtung gegenüber Wasser und Vakuum und eine leichte, oftmals wiederholbare verschleissarme Verbindung und Trennung von Tragwelle(n) und Targetrohren ohne Bedarf grosser Freiräume und Zeitspannen für die erforderlichen Manipulationen herbeiführbar sind. Ferner soll ein extrem guter Rundlauf bei konstanter Achslage gewährleistet sein.

Die Lösung der gestellten Aufgabe erfolgt dabei erfindungsgemäß durch die Merkmale im Kennzeichen des Patentanspruchs 1.

Es wird dadurch erreicht, dass gleichzeitig eine hohe und hoch belastbare Koaxialität von Tragwelle(n) und Targetrohren, eine zuverlässige Abdichtung zwischen Wasser und Vakuum und eine leichte, oftmals wiederholbare verschleissarme Verbindung und Trennung von Tragwelle(n) und Targetrohren ohne Bedarf grosser Freiräume und Zeitspannen für die erforderlichen Manipulationen herbeiführbar sind. Ferner ist ein extrem guter Rundlauf bei konstanter Achslage aller rotierenden Teile gewährleistet.

Weitere vorteilhafte Ausgestaltungen des Erfindungsgegenstandes ergeben sich - entweder einzeln oder in Kombination - aus den Unteransprüchen, wobei betont wird, dass die Merkmale nach den Ansprüchen 2, 3 und 4 auch unabhängig voneinander mit den Merkmalen des Patentanspruchs 1 einsetzbar sind, wohl aber auch miteinander kombiniert werden können.

Ausführungsbeispiele des Erfindungsgegenstandes und deren Wirkungsweisen und zusätzliche Vorteile werden nachfolgend anhand der Figuren 1 bis 8 näher erläutert.

Es zeigen:
- Figur 1: einen Axialschnitt durch eine ortsfeste Tragstruktur für eine Tragwelle, eine lösbare Kupplungsanordnung und das kupplungsseitige Ende des drehbaren Targetrohres und des darin untergebrachten Magnetsystems,
- Figur 2: die Anordnung nach Figur 1 in teilweise entkuppeltem Zustand,
- Figur 3: einen Ausschnitt aus dem rechten Teil der Figur 2, in vergrössertem Massstab,
- Figur 4: einen Axialschnitt durch die funktionswesentlichen Teile des Antriebs,
- Figur 5: einen Radialschnitt entlang der Linie V-V in Figur 3,
- Figur 6: eine perspektivische Darstellung einer Bajonettverbindung, wie sie für die Verbindung eines Ringflansches und eines Spannrings verwendet werden kann,
- Figur 7: eine perspektivische Explosionsdarstellung einer getrennten Kupplungsanordnung zwischen einer antreibbaren Tragwelle und einem Targetrohr und
- Figur 8: eine perspektivische Darstellung der Kupplungsanordnung nach Figur 7 in geschlossenem bzw. gekuppeltem Zustand.

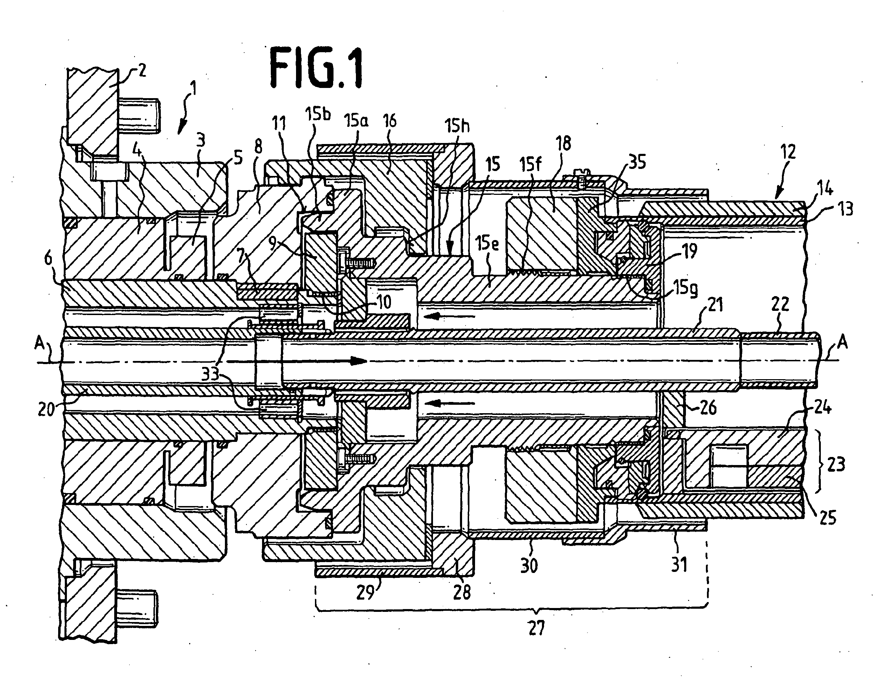

In Figur 1 ist links eine Tragkonstruktion 1 dargestellt, die aus einer senkrechten Platte 2 und einem fest eingesetzten Tragrohr 3 besteht. In dieses ist abgedichtet eine Vakuumdrehdurchführung 4 eingesetzt, an deren rechtem Ende sich ein radial verspannbarer Fortsatz 5 befindet. In diese Vakuumdrehdurchführung 4 ist eine drehbare Tragwelle 6 eingesetzt, auf deren rechtes Ende über einen Keil 7 ein Ringflansch 8 verdrehfest aufgesteckt ist, der in axialer Richtung durch einen Stützring 9 mittels einer Gewindeverbindung 10 festgelegt ist. Zwischen dem Aussenumfang des Stützringes 9 und und dem Ringflansch 8 befindet sich ein koaxialer achsparalleler Ringspalt, der ein erstes Formschlusselement 11 bildet.

Die System-Achse A-A, deren Raumlage beliebig gewählt werden kann, ist durch eine gestrichelte Linie angedeutet. Die Tragkonstruktion 1 kann im Innern einer nicht gezeigten Vakuumkammer, an einer der Seitenwände, auf dem Boden oder an der Decke der Vakuumkammer befestigt sein.

Rechts ist das Ende eines drehbaren Targetrohres 12 gezeigt, das aus einem Tragrohr 13 und einem Belag 14 aus einem Beschichtungsmaterial, besteht, das entweder in einer nicht-reaktiven Atmosphäre (z.B. Argon) auf einem nicht gezeigten Substrat oder in einer reaktiven Atmosphäre als Verbindung des Belages 14 kondensiert werden kann. Das Substrat wird dabei durch eine Führung parallel zur Achse A-A und senkrecht zur Zeichenebene bewegt. Diese Vorgänge sind jedoch bekannt und werden daher nicht näher beschrieben. Beispielsweise können Tragrohr 13 und Belag 14 aus dem gleichen Material bestehen, wenn dieses eine ausreichende Festigkeit besitzt.

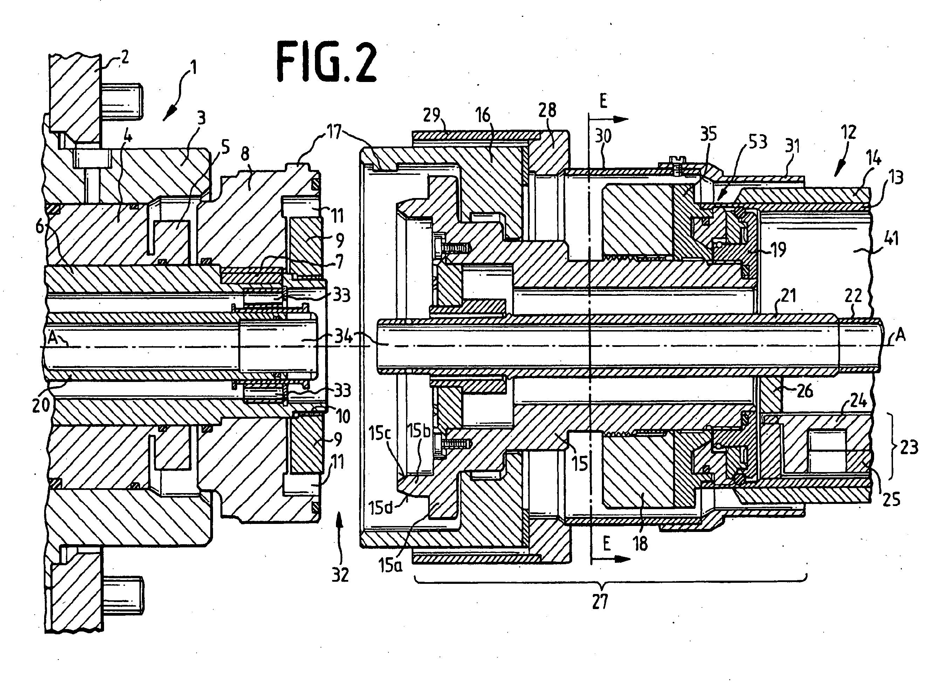

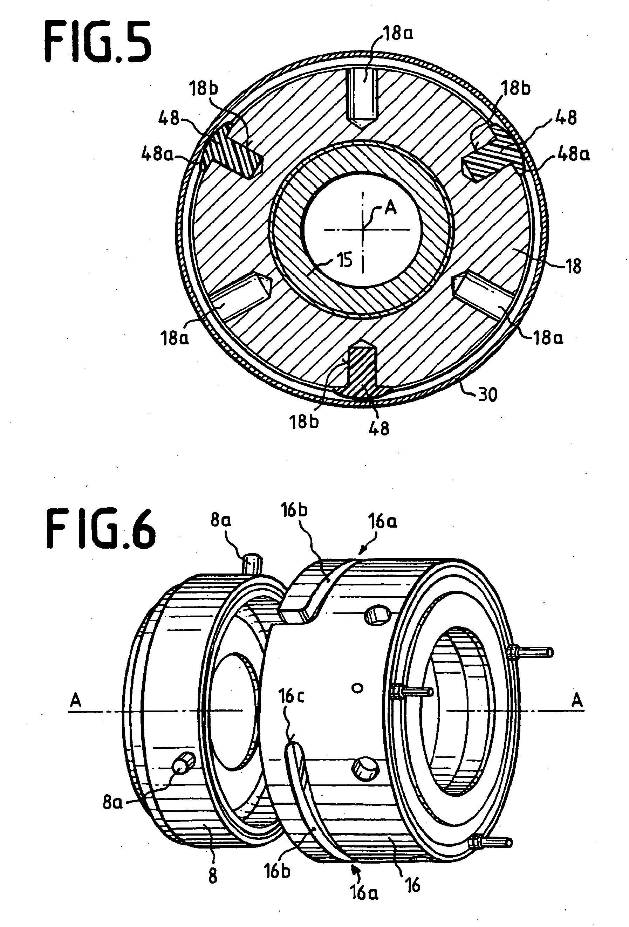

Die drehfeste Verbindung zwischen der Tragwelle 6 und dem Targetrohr 12 geschieht durch folgende Mittel: Zwischen dem Ringflansch 8 und dem Targetrohr 12 befindet sich ein stärker umrandetes Distanzstück 15 mit einem Ringflansch 15a und einem koaxialen Ringfortsatz 15b, der in das erste Formschlusselement 11 eingreift. Zum leichteren Einfädeln und zur Zentrierung ist der Ringfortsatz 15b innen und aussen mit Kegelstumpfflächen 15c und 15d versehen (Figur 2). Den Ringflansch 15a übergreift ein erster einteiliger Spannring 16 mit mindestens einem zweiten lösbaren Formschlusselement 17. Die Verbindung lässt sich durch Schrägflächen, wie ein Bajonettsystem (gemäss Figur 6) oder Gewinde konzentrisch festziehen.

Im weiteren Verlauf des Distanzstückes 15 besitzt dieses einen hohlzylindrischen Fortsatz 15e mit zwei Aussengewinden 15f und 15g. Auf diesen Fortsatz sind ein zweiter einteiliger Spannring 18 und ein Widerlager 19 aufgeschraubt. Der Spannring 16 drückt auf eine Ringfläche 15h des Distanzstücks 15.

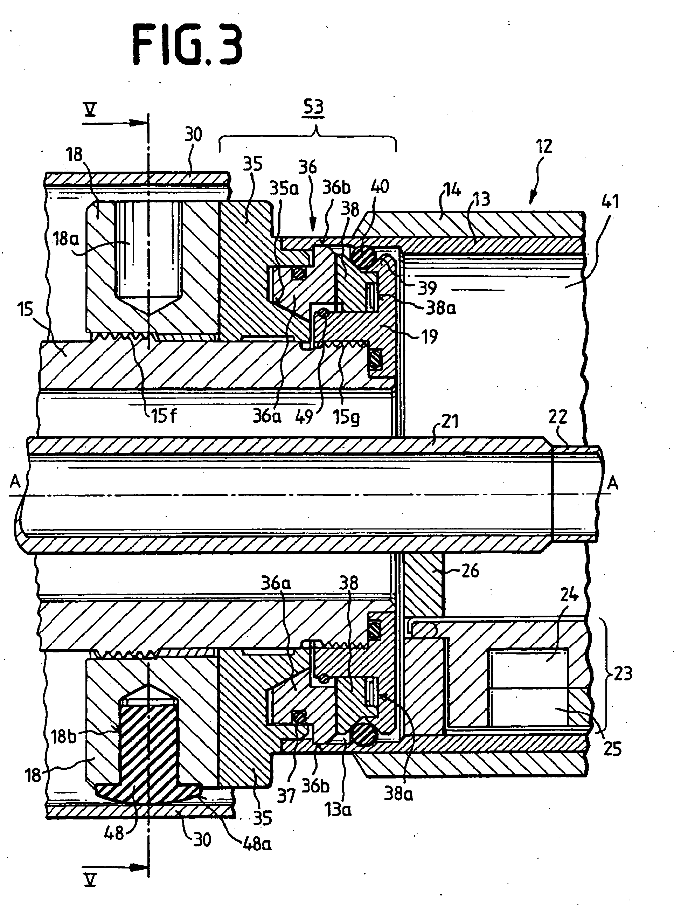

Im Innern der Tragwelle 6, des Distanzstückes 15 und des Targetrohrs 12 befindet sich - konzentrisch oder parallel zur Achse A-A - ein Tragsystem von Rohrleitungen 20, 21 und 22, die einen Träger für ein bekanntes ortsfestes Magnetsystem 23 bildet, das aus Jochen 24 und Magneten 25 besteht. Die Aufhängung und Lagefixierung erfolgen durch Stützelemente 26, von denen nur eines dargestellt ist. Die vakuumdichte Kühlmittelführung ist durch dicke Pfeile dargestellt. Einzelheiten und Wirkungen werden anhand der Figur 3 näher erläutert.

Die Figur 2 zeigt - unter Beibehaltung der bisherigen Bezugszeichen - die Anordnung nach Figur 1 in teilweise entkuppeltem Zustand. Zusätzlich wird folgendes angegeben:

Nahezu der gesamte Bereich des Distanzstückes 15 ist von einer rotationssymmetrischen und koaxialen Dunkelraumabschirmung 27 umgeben, die aus einem Verbindungsring 28 und Hohlzylindern 29, 30 und 31 besteht, wobei der Hohlzylinder 31 das Ende des Targetrohres 12 noch geringfügig übergreift.

In Figur 2 sind die Tragwelle 6 mit dem Ringflansch 8 an einer ersten Trennstelle 32 entkoppelt, nachdem der Spannring 16 von dem Ringflansch 8 gelöst wurde. Das der ersten Trennstelle 32 zugekehrte Ende der Rohrleitung 20 ist in der Tragwelle 6 durch einen Lagerring aus Kunststoff mit Bohrungen 33 für einen Kühlmitteldurchtritt koaxial gelagert. Der Ringflansch 15a ist aus dem Formschlusselement 11 heraus gezogen, desgleichen die Rohrleitung 21 aus einer Steckverbindung 34 mit der Rohrleitung 20. Die Dunkelraumabschirmung 27 lässt sich in Richtung des Targetrohres 12 koaxial verschieben und auch zerlegen, um Werkzeuge an den Spannringen 16 und 18 ansetzen zu können. Die komplexe Baugruppe rechts von der Trennstelle 32 lässt sich jetzt aus der Vakuumkammer herausnehmen.

Es wird betont, dass diese komplexe Baugruppe bei relativ kurzen Targetrohren 12 fliegend gelagert sein kann, oder dass bei relativ langen Targetrohren 12 an deren jenseitigem, rechten Ende eine zusätzliche Lagerung angeordnet werden kann, die hier jedoch nicht gezeigt ist. Die Grenze liegt zwischen etwa 100 und 200 cm.

Die Figur 3 zeigt - unter Beibehaltung der bisherigen Bezugszeichen - vergrössert die Anordnung nach Figur 2 rechts von der radialen Ebene E-E in Figur 2 - allerdings im Betriebszustand. Der Spannring 18 besitzt auf dem Umfang sich abwechselnde Bohrungen 18a und 18b. In die Bohrungen 18a sind stabförmige Drehwerkzeuge einsteckbar. In die Bohrungen 18b sind pilzförmige Stützkörper 48 mit kalottenförmigen Aussenflächen 48a eingesetzt, auf denen sich der Hohlzylinder 30 der Dunkelraumabschirmung 27 abstützt.

Zwischen dem Spannring 18 und dem auf dem Tragrohr 13 verdrehfest und abgedichtet aufgeschraubten ringförmigen Widerlager 19 befindet sich eine zweite Trennstelle 53. Die Trennstellen 32 und 53 sind völlig unabhängig zu betrachten. Sie können im Rahmen des Anspruchs 1 völlig unabhängig voneinander gestaltet werden und haben im Rahmen des Ausführungsbeispiels keinen zwingenden kombinatorischen Charakter.

Die Figur 3 zeigt Innerhalb der Trennstelle 53 einen axial verschiebbaren Druckring 35, der eine konzentrische Kegelstumpffläche 35a besitzt. Auf dieser ist eine Spreizvorrichtung 36 angeordnet, die aus sektorförmigen Spreizbacken 36a mit Aussenflächen 36b angeordnet, die durch Verdrehen des Spannringes 18, in eine innere ringförmige Ausnehmung 13a des Tragrohres 13 in radialen Richtungen einschiebbar sind, um das Tragrohr 13 in axialer und radialer Richtung festzulegen. Beim Zurückschrauben des Spannrings 18 werden die Spreizbacken 36a durch eine Ringfeder 37 zur Freigabe des Targetrohres 12 radial zusammengezogen.

Zwischen den Spreizbacken 36 und dem Widerlager 19 ist ein weiterer Druckring 38 angeordnet, der zusammen mit dem Widerlager 19 eine nach außen offene V-förmige Ringnut 39 einschliesst, in der sich ein elastomerer Dichtungsring 40 befindet. Beim Verspannen der Vorrichtung wird der Dichtungsring 40 gegen eine zylindrische Innenfläche des Tragrohres 13 gepresst, um den mit Kühlmittel gefüllten Raum 41 innerhalb des Tragrohres 13 und des Targetrohres 12 gegen das Vakuum in der Vakuumkammer abzudichten.

Zwecks Aufhebung des Montagezustandes nach Figur 3 wird der Spannring 18 nach links zurück geschraubt. Dadurch wird der Druckring 35 axial frei beweglich. Die Ringfeder 37 zieht sich zusammen, wodurch die Spreizbacken 36a auf der Kegelstumpffläche 35a abgleiten und ihre Aussenflächen 36b das Tragrohr 13 mit dem Belag 14 aus Zerstäubungsmaterial freigeben. Der Bewegung folgt der Druckring 38 unter der Wirkung einer wellenförmigen Ringfeder 38a bis zu einem Begrenzungsring 49 aus einem einseitig offenen Federstahldraht, wodurch sich die Ringnut 39 verbreitert und sich der Dichtungsring 40 zusammenziehen kann und sich gleichfalls vom Tragrohr 13 löst. Das Targetrohr 12 kann jetzt in axialer Richtung nach rechts abgezogen werden. Die Wiederherstellung des Betriebszustandes nach den Figuren 1 und 3 erfolgt in umgekehrtem Sinne.

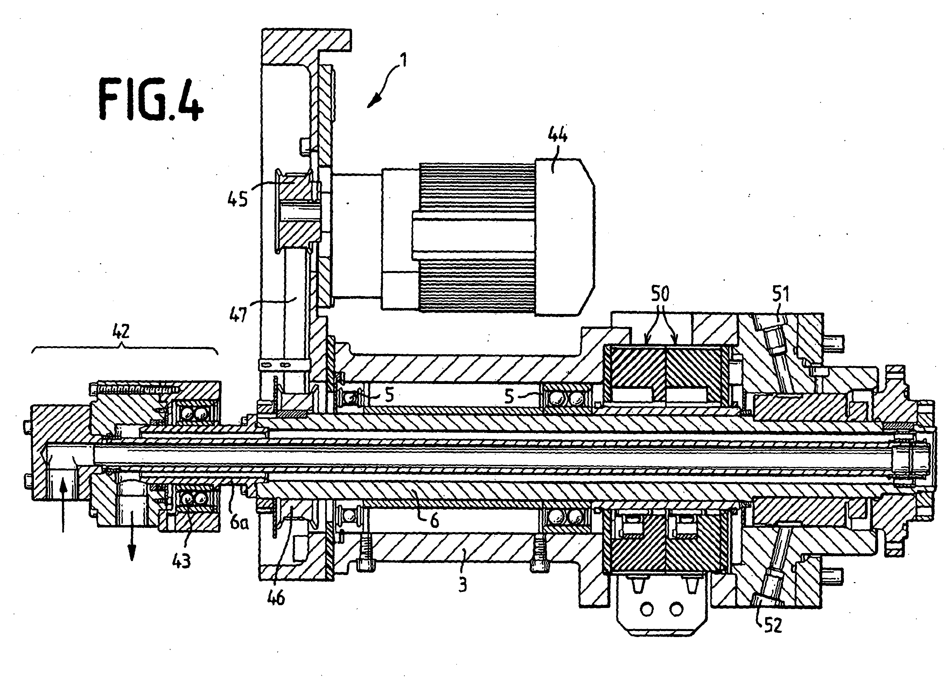

In Figur 4 ist - unter Fortschreibung der Bezugzeichen - die Tragkonstruktion 1 frei im Raum dargestellt. In dem Tragrohr 3 ist die Tragwelle 6 über die Wälzlager 5 drehbar gelagert. Die Tragwelle 6 besitzt eine Verlängerung 6a, auf der über Wälzlager 43 eine Rotationskupplung 42 für eine Kühlmittelzufuhr und -abfuhr ortsfest gelagert ist. Derartige Rotationskupplungen 42 für Flüssigkeiten sind jedoch - an sich - bekannt, so dass auf die Schilderung weiterer Einzelheiten verzichtet werden kann. Der Antrieb der Tragwelle 6 erfolgt über einen Motor 44, zwei Riemenscheiben 45 und 46 und einen Treibriemen 47. Für die Zuführung der Zerstäubungsspannung sind Schleifkontakte 50 vorgesehen. Für die Zufuhr und Abfuhr von Kühlmittel sind Anschlusskanäle 51 und 52 vorgesehen.

Die Figur 5 zeigt einen Radialschnitt entlang der Linie V-V in Figur 3. Auf dem Umfang des Spannrings 18 sind in äqudistanter Verteilung und radialen Richtungen Bohrungen 18a für das Einstecken eines stabförmigen Werkzeugs und 18b für das Einsetzen der Stützkörper 48 angeordnet, die pilzförmig gestaltet und mit kalottenfömigen Aussenflächen 48a versehen sind, auf denen sich die mitdrehende Dunkelraumabschirmung 27 stationär abstützt.

Die Figur 6 zeigt eine perspektivische Darstellung einer Bajonettverbindung, wie sie für die Verbindung eines Ringflansches 8 und eines Spannrings 16 verwendet werden kann. Der Ringflansch 8 ist am Ende der - hier nicht gezeigten - Tragwelle 6 verdrehfest befestigt; auf seinem Umfang sind in äquidistanter Verteilung drei Zylinderzapfen 8a angeordnet. Im Spannring 16 befinden sich in analoger Anordnung drei L-förmige Spalte 16a mit achsparallelen Einläufen und Flanken 16b, die zu ihren Enden 16c hin in axialer Richtung nach rechts wählbar ansteigend verlaufen, so dass sich die Bajonettverbindung beim Zusammenstecken und Verdrehen feinfühlig und kraftsparend festziehen und wieder lösen lässt. Die Verschraubung kann durch hier nicht gezeigte Arretierschrauben ohne Werkzeuge unlösbar gemacht werden.

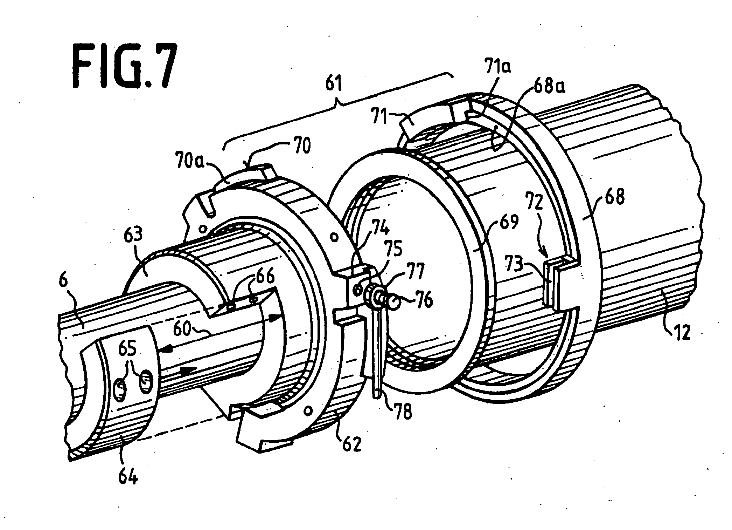

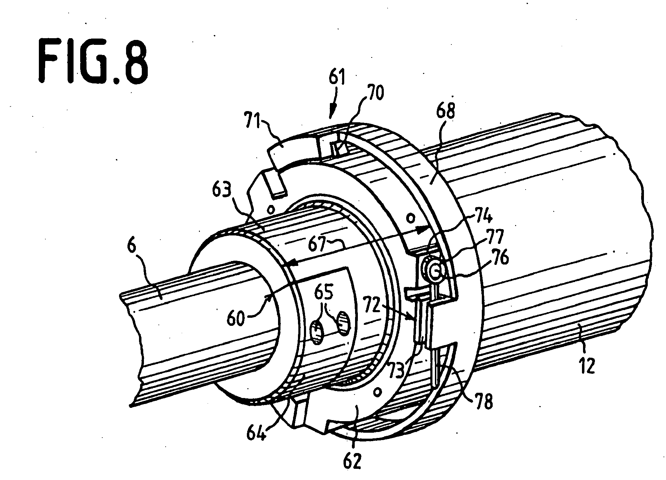

In Figur 7 ist links das kammerinnere Ende einer solchen Tragwelle 6 dargestellt, auf der links eine erste Trennstelle 60 und rechts daneben eine zweite Trennstelle 61 angeordnet sind. Die erste Trennstelle 60 wird durch einen Ringflansch 62 mit einer Nabe 63 gebildet, die auf einem Teil ihrer Länge halbiert und an dieser Stelle durch ein halbringförmiges Druckstück 64 ergänzt wird, das hier nur teilweise dargestellt ist. Die Verbindung erfolgt durch Einschieben in Pfeilrichtung und Verspannen mittels Schrauben und Schraublöchern 65 und 66. Diese dann rotationssymmetrische dreh- und biegefeste Verspannung bildet zusammen mit dem Ringflansch 62 ein Distanzstück 67 (Figur 8).

Die zweite Trennstelle 61 besteht aus zwei formschlüssig miteinander verbindbaren Teilen, nämlich dem Ringflansch 62 und einem Spannring 68. Die Verbindung erfolgt zunächst durch Heranschieben eines Targetrohres 12 nach links, das an mindestens einem Ende einen radial nach aussen abstehenden Ringflansch 69 besitzt. Das Targetrohr 12 kann bei mechanisch hochstabilen Zerstäubungsmaterialien monolithisch aufgebaut sein, bei weniger stark beanspruchbaren nichtmetallischen Werkstoffen aber auch aus einem metallischen Innenrohr und einem äusseren Belag aus Zerstäubungsmaterialien wie z.B. aus Si, Zn, SiAl etc. bestehen.

Die Fixierung des Ringflanschs 69 und damit des Targetrohres 12 erfolgt form- und kraftschlüssig durch den Spannring 68, der Teil einer Bajonettverbindung und über den Ringflansch 69 und den Ringflansch 62 nach links verschiebbar und gegenüber dem Ringflansch 62 auch verdrehbar ist. Zur Herstellung der Formschlüssigkeit besitzt der Ringflansch 62 auf seinem Aussenumfang mindestens eine Rastnase 70, die nach dem Verdrehen des Spannringes 68 von je einem hakenförmigen Ringsektor 71 übergriffen ist. Die sich dabei übergreifenden Flanken 70a der Rastnase(n) 70 und der Innenfläche(n) 71a der Ringsektoren 71 können dabei in Achsrichtung einen Flankenwinkel geringer Steigung (ähnlich wie bei einem Gewinde) einschliessen. Der Spannring 68 besitzt eine stufenförmige Vertiefung 68a.

Zur Fixierung des Verdrehwinkels besitzt der Spannring 68 ein Gabelteil 72 mit einem tangentialen Spalt 73. Andererseits besitzt der Ringflansch 62 einen radialen Vorsprung 74 mit einem Schraubloch 75, in das eine Spannschraube 76. eingeschraubt ist. Zwischen dem Vorsprung 74 und dem Kopf der Spannschraube 76 befindet sich ein Ring 77, von dem radial zur Schraubenachse, aber tangential zum Ringflansch 62 ein Arretierstift 78 absteht, der in zusammengeschobenem Zustand nach Figur 8 in den Spalt 73 eingreift.

Die Figur 8 zeigt eine perspektivische Darstellung der Kupplungsanordnung nach Figur 7 in geschlossenem bzw. gekuppeltem Zustand. Es ist zu erkennen, dass sich die Nabe 63 und das Druckstück 64, fest miteinander und mit der Tragwelle 6 verschraubt, zu einem Rotationskörper ergänzen, der auch mit dem Ringflansch 62 eine - allerdings lösbare - Einheit bildet.

Der Ringflansch 69 des Targetrohres 12 ist zwischen dem Ringflansch 62 und dem Spannring 68 verdeckt angeordnet. Allerdings ist jetzt sichtbar, dass die Rastnase 70 ein kurzes Stück hinter dem Ringsektor 71 herausragt und auf diese Weise eine formschlüssige Verbindung bildet. Dies gilt auch für etwaige weitere Verbindungen dieser Art. Der Ringflansch 69 des Targetrohres 12 liegt in der Vertiefung 68a des Spannrings 68. Die Spannschraube 76 ist angezogen, und der Arretierstift 78 liegt jetzt innerhalb des Spaltes 73.

Im Innern des rotierbaren Targetrohres 12 befindet sich - wie in den Figuren 1 bis 4 auch - ein hier nicht dargestelltes, nicht rotierendes Magnetsystem, unter dessen Feldlinien das Targetrohr 12 im Betrieb hindurch läuft. Träger und Leitungen für das Magnetsystem und dessen Kühlmittel verlaufen durch die Tragwelle 6 bis in das Targetrohr 12, sind aber gleichfalls hier nicht dargestellt.

### Bezugszeichenliste:

- 1: Tragkonstruktion
- 2: Platte
- 3: Tragrohr
- 4: Vakuum-Drehdurchführung
- 5: Fortsatz
- 6: Tragwelle
- 6a: Verlängerung
- 7: Keil
- 8: Ringflansch
- 8a: Zylinderzapfen
- 9: Stützring
- 10: Gewindeverbindung
- 11: Formschlusselement
- 12: Targetrohr
- 13: Tragrohr
- 13a: Ausnehmung
- 14: Belag
- 15: Distanzstück
- 15a: Ringflansch
- 15b: Ringfortsatz
- 15c: Kegelstumpffläche
- 15d: Kegelstumpffläche
- 15e: Fortsatz
- 15f: Aussengewinde
- 15g: Aussengewinde
- 15h: Anschlagfläche
- 16: Spannring
- 16a: Spalte
- 16b: Flanken
- 16c: Enden
- 17: Formschlusselement
- 18: Spannring
- 18a: Bohrungen
- 18b: Bohrungen
- 19: Widerlager
- 20: Rohrleitung
- 21: Rohrleitung
- 22: Rohrleitung
- 23: Magnetsystem
- 24: Joche
- 25: Magnete
- 26: Stützelemente
- 27: Dunkelraumabschirmung
- 28: Verbindungsring
- 29: Hohlzylinder
- 30: Hohlzylinder
- 31: Hohlzylinder
- 32: erste Trennstelle
- 33: Bohrungen
- 34: Steckverbindung
- 35: Druckring
- 35a: Kegelstumpffläche
- 36: Spreizvorrichtung
- 36a: Spreizbacken
- 36b: Aussenflächen
- 37: Ringfeder
- 38: Druckring
- 38a: Ringfeder
- 39: Ringnut
- 40: Dichtungsring
- 41: Raum
- 42: Rotationskupplung
- 43: Wälzlager
- 44: Motor
- 45: Riemenscheibe
- 46: Riemenscheibe
- 47: Treibriemen
- 48: Stützkörper
- 48a: Aussenflächen
- 49: Begrenzungsring
- 50: Schleifkontakte
- 51: Anschlusskanal
- 52: Anschlusskanal
- 53: zweite Trennstelle
- 60: erste Trennstelle
- 61: zweite Trennstelle
- 62: Ringflansch
- 63: Nabe
- 64: Druckstück
- 66: Schraublöcher

- 67: Distanzstück
- 68: Spannring
- 68a: Vertiefung
- 69: Ringflansch
- 70: Rastnase
- 70a: Flanke(n)
- 71: Ringsektor
- 71a: Innenfläche(n)
- 72: Gabelteil
- 73: Spalt
- 74: Vorsprung
- 75: Schraubloch
- 76: Spannschraube
- 77: Ring
- 78: Arretierstift

- A-A: Achse/System-Achse
- E-E-: radiale Ebene

## Patentansprüche

1. Katodenanordnung zur Zerstäubung eines Targetrohres (12) mit einem nicht drehbaren Magnetsystem (23) zur Erzeugung eines Magnetfeldes zum Einschluss eines Plasmas, wobei das Targetrohr (12) innerhalb einer Vakuumkammer durch das Magnetfeld hindurch drehbar ist, wobei in mindestens einer Tragkonstruktion (1) eine antreibbare Tragwelle (6) für das Targetrohr (12) angeordnet ist, wobei ferner innnerhalb des Targetrohres (12) eine Halterung für das Magnetsystem (23) angeordnet ist und wobei zwischen der Tragwelle (6) und dem Targetrohr (12) mindestens eine lösbare Kupplungsanordnung für das Auswechseln des Targetrohres (12) angeordnet ist,
**dadurch gekennzeichnet, dass**
mindestens zwischen der antreibbaren Tragwelle (6) und dem Targetrohr (12) ein hierzu koaxiales Distanzstück (15, 67) und zwei lösbare Trennstellen (32/53) bzw. (60/61) angeordnet sind, und dass durch die Trennstellen (32/53) bzw. (60/61) die drehfesten und formsteifen Verbindungen zwischen der Tragwelle (6) und dem Distanzstück (15,67) einerseits und dem Distanzstück (15, 67) und einem Targetrohr (12) andererseits lösbar und wieder herstellbar sind; und dass im Innern der Tragwelle (6) eine erste Rohrleitung (20), im Innern des Distanzstücks (15) eine zweite Rohrleitung (21) und im Innern des Targetrohres (12) eine dritte Rohrleitung (22) für die Halterung des Magnetsystems (23) angeordnet sind, wobei die erste und die zweite Rohrleitung (20, 21) durch eine axial lösbare, aber verdrehfeste Steckverbindung (34) miteinander verbunden sind.

2. Katodenanordnung nach Anspruch 1, weiter **dadurch gekennzeichnet, dass** die erste Trennstelle (32) zwischen einem Ringflansch (8) auf der Tragwelle (6) und dem Distanzstück (15) und die zweite Trennstelle (53) zwischen dem Distanzstück (15) und der Innenseite des Targetrohres (12) angeordnet sind.

3. Katodenanordnung nach Anspruch 1, weiter **dadurch gekennzeichnet, dass**
a) die Tragwelle (6) innerhalb der Vakuumkammer mit einem Ringflansch (8) mit einem ersten Formschlusselement (11) versehen ist,
b) zwischen dem Ringflansch (8) und dem Targetrohr (12), das Distanzstück (15) von einem ersten einteiligen Spannring (16) mit einem zweiten Formschlusselement (17) umgeben ist, durch den das Distanzstück (15) koaxial und verdrehfest gegen den Ringflansch (8) der Tragwelle (6) verspannbar ist.

4. Katodenanordnung nach Anspruch 1, weiter **dadurch gekennzeichnet, dass** das Distanzstück (15) von einem zweiten einteiligen Spannring (18) umgeben ist, der in entgegengesetzter Richtung zum ersten Spannring (8) auf radial bewegliche Spreizbacken (36a) einer Spreizvorrichtung (36) zur Einwirkung bringbar ist, durch die das zugehörige Ende des Targetrohres (12) koaxial und verdrehfest mit dem Distanzstück (15) verspannbar ist.

5. Katodenanordnung nach Anspruch 1, weiter **dadurch gekennzeichnet, dass** das erste Formschlusselement (11) als koaxialer Ringspalt in dem Ringflansch (8) und das zweite Formschlusselement (17) am Aussenumfang des Ringflanschs (8) ausgebildet sind.

6. Katodenanordnung nach Anspruch 1, weiter **dadurch gekennzeichnet, dass** der Ringflansch (8) der Tragwelle (6) eine koaxiale Ausnehmung für das axiale und radial formschlüssige Einführen eines koaxialen und ringförmigen Ringfortsatzes (15b) am targetfernen Ende des Distanzstücks (15) aufweist.

7. Katodenanordnung nach Anspruch 6, weiter **dadurch gekennzeichnet, dass** das Distanzstück (15) einen nach aussen ragenden Ringflansch (15a) besitzt, an dem der Ringfortsatz (15b) angeordnet ist.

8. Katodenanordnung nach Anspruch 7, weiter **dadurch gekennzeichnet, dass** das Distanzstück (15) auf der dem Ringflansch (15b) abgekehrten Seite eine ringförmige Anschlagfläche (15h) für den ersten Spannring (16) aufweist.

9. Katodenanordnung nach Anspruch 1, weiter **dadurch gekennzeichnet, dass** das Distanzstück (15) auf seiner dem Targetrohr (12) zugekehrten Seite ein Aussengewinde (15f) für den zweiten Spannring (18) besitzt, durch den eine radiale Spreizvorrichtung (36) gegen eine Innenfläche des Targetrohres (12) verspannbar ist.

10. Katodenanordnung nach Anspruch 9, weiter **dadurch gekennzeichnet, dass** die radiale Spreizvorrichtung (36) mindestens drei sektorförmige Spreizbacken (36a) mit inneren Kegelstumpfflächen aufweist.

11. Katodenanordnung nach Anspruch 9, weiter **dadurch gekennzeichnet, dass** die Sektoren der Spreizbacken (36a) durch eine äussere Ringfeder (37) zusammenziehbar gehalten sind.

12. Katodenanordnung nach mindestens einem der Ansprüche 8 bis 10, weiter **dadurch gekennzeichnet, dass** zwischen dem zweiten Spannring (18) und der Spreizvorrichtung(36) ein Druckring (35) angeordnet ist, der eine zu den Kegelstumpfflächen der Spreizbacken (36a) zumindest weitgehend komplementäre äussere Kegelstumpffläche (35a) besitzt.

13. Katodenanordnung nach Anspruch 1, weiter **dadurch gekennzeichnet, dass** der erste Spannring (8) für die Verbindung des Distanzstücks (15) mit der Tragwelle (6) auf der dem Targetrohr (12) zugekehrten Seite eine ringförmige Ausnehmung als Formschlusselement (11) für den Ringflansch (15a) des Distanzstücks (15) aufweist.

14. Katodenanordnung nach mindestens einem der Ansprüche 1 bis 4, weiter **dadurch gekennzeichnet, dass** die beiden Spannringe (16, 18) von einer Dunkelraumabschirmung (27) umgeben sind.

15. Katodenanordnung nach mindestens einem der Ansprüche 1 bis 4, weiter **dadurch gekennzeichnet, dass** zumindest der Spannring (18) auf seinem Umfang mit Bohrungen (18a) für das Einstecken eines Werkzeugs versehen ist.

16. Katodenanordnung nach Anspruch 4, weiter **dadurch gekennzeichnet, dass** der Spannring (18) auf seinem Umfang mit Bohrungen (18b) versehen ist, in die Stützkörper (48) für die stationäre Abstützung der Dunkelraumabschirmung (27) auf dem rotierbaren Spannring (18) eingesetzt sind.

17. Katodenanordnung nach Anspruch 1, weiter **dadurch gekennzeichnet, dass**
a) ein erstes angetriebenes Rohr als Tragwelle (6) ausgebildet ist, die in der Vakuumkammer endet, und an diesem Ende ein koaxiales Distanzsfück (67), bestehend aus einem Ringflansch (62), einer Nabe (63) und einem Druckstück (64) trägt,
b) die Nabe (63) eine halbringförmige Ausnehmung für das hierzu komplementäre Druckstück (64) besitzt, und dieses Druckstück (64) kraftschlüssig und verdrehfest gegen die Tragwelle (6) verspannbar ist,
c) die Nabe (63) mit einem Ringflansch (62) verbunden ist, der auf seinem Umfang mindestens eine Rastnase (70) für den Eingriff in einen Ringsektor (71) eines axial folgenden Spannrings (68) trägt.
d) der Spannring (68) auf seinem Umfang den mindestens einen Ringsektor (71) für den formschlüssigen übergriff über die Rastnase (70) besitzt, und dass
e) das Targetrohr (12) einen radial nach aussen abstehen Ringflansch (69) besitzt, der beim Verbinden von Ringflansch (62) und Spannring (68) zwischen diesen zur Mitdrehung des Targetrohrs (12) einspannbar ist.

18. Katodenanordnung nach Anspruch 17, weiter **dadurch gekennzeichnet, dass** der das Targetrohr (12) umgreifende Spannring (68) auf seinem Umfang mindestens ein Gabelteil (72) mit einem tangential ausgerichteten Spalt (73) besitzt, in den ein am Ringflansch (62) drehbar befestigter Arretierstift (18) einführbar ist.

19. Katodenanordnung nach Anspruch 18, weiter **dadurch** gekennzeichet, dass der Ringflansch (62) auf seinem Umfang mindestens einen Vorsprung (74) mit einem Schraubloch (75) besitzt, in das eine Spannschraube (76) unter Zwischenschaltung eines Rings (77) einschraubbar ist und dass der Arretierstift (78) radial zur Spannschraube (76), aber tangential zum Umfang des Ringflansches (62) verlauft.

## Claims

1. Cathode assembly for sputtering a target pipe (12), with a non-rotatable magnet system (23) for producing a magnetic field for enclosing a plasma, whereby the target pipe (12) is rotatable through the magnetic field within a vacuum chamber, whereby a driveable support shaft (6) is provided for the target pipe (12) in at least one support construction (1), whereby a holder for the magnet system (23) is further located within the target pipe (12), and whereby at least one disconnectable coupling arrangement for replacing the target pipe (12) is located between the support shaft (6) and the target pipe (12), **characterised in that** a coaxial distancer (15, 67) and two disconnectable separation points (32/53), e.g. (60/61) are located at least between the driveable support shaft (6) and the target pipe (12), and **in that** the separation points (32/53), e.g. (60/61) enable the rotation resistant and rigid connection of the support shaft (6) with the distancer (15, 67) on the one hand, and the distancer (15, 67) and the target pipe (12) can be disconnected and re-connected on the other hand; and **in that** a first pipeline (20) is located inside the support shaft (6), a second pipeline (21) inside the distancer (15), and a third pipeline (22) inside the target pipe (12) for holding the magnet system (23), whereby the first and second pipelines (20, 21) are connected with each other via an axially disconnectable, but rotation resistant plug connection (34).

2. Cathode assembly according to Claim 1, further **characterised in that** the first separation point (32) is located between an annular flange (8) on the support shaft (6) and the distancer (15), and the second separation point (53) between the distancer (15) and the inside of the target pipe (12).

3. Cathode assembly according to Claim 1, further **characterised in that**
a) the support shaft (6) is equipped with an annular flange (8) with a first form closure element (11) within the vacuum chamber,
b) the distancer (15) is surrounded by a first single-piece tensioning ring (16) with a second form closure element (17) between the annular flange (8) and the target pipe (12), through which the distancer (15) can be coaxially and rotation resistantly tensioned against the annular flange (8) of the support shaft (6).

4. Cathode assembly according to Claim 1, further **characterised in that** the distancer (15) is surrounded by a second single-piece tensioning ring (18), which can be positioned on the radially moveable spreading jowls (36a) of a spreading means (36) in the opposite direction to that of the first tensioning ring (8), with which the associated end of the target pipe (12) can be coaxially and rotation resistantly tensioned against the distancer (15).

5. Cathode assembly according to Claim 1, further **characterised in that** the first form closure element (11) takes the form of a coaxial annular gap in the annular flange (8), and the second form closure element (17) is formed on the outer circumference of the annular flange (8).

6. Cathode assembly according to Claim 1, further **characterised in that** the annular flange (8) of the support shaft (6) comprises a coaxial recess for the axial and radial form closure insertion of a coaxial and annular ring extension (15b) on the end of the distancer (15) furthest from the target.

7. Cathode assembly according to Claim 6, further **characterised in that** the distancer (15) comprises an annular flange (15a) projecting towards the outside, on which the ring extension (15b) is located.

8. Cathode assembly according to Claim 7, further **characterised in that** the distancer (15) comprises an annular abutment surface (15h) for the first tensioning ring (16) on the side facing away from the annular flange (15b).

9. Cathode assembly according to Claim 1, further **characterised in that** the distancer (15) comprises an external thread (15f) for the second tensioning ring (18) on its side facing the target pipe (12), with which a radial spreading means (36) can be tensioned against an inner surface of the target pipe (12).

10. Cathode assembly according to Claim 9, further **characterised in that** the radial spreading means (36) comprises at least three sector-shaped spreading jowls (36a) with internal frustoconical surfaces.

11. Cathode assembly according to Claim 9, further **characterised in that** the sectors of the spreading jowls (36a) are held by an outer annular spring (37) in a contractible way.

12. Cathode assembly according to at least one of the Claims 8 to 10, further **characterised in that** a pressure ring (35) is located between the second tensioning ring (18) and the spreading means (36), which comprises an outer frustoconical surface (35a) that is at least substantially complimentary to the frustoconical surfaces of the spreading jowls (36a).

13. Cathode assembly according to Claim 1, further **characterised in that** the first tensioning ring (8) comprises an annular recess as the form closure element (11) for the annular flange (15a) of the distancer (15) on the side facing the target pipe (12) for connecting the distancer (15) with the support shaft (6).

14. Cathode assembly according to at least one of the Claims 1 to 4, further **characterised in that** the two tensioning rings (16, 18) are surrounded by a dark chamber shield (27).

15. Cathode assembly according to at least one of the Claims 1 to 4, further **characterised in that** at least the tensioning ring (18) is equipped with bores (18a) for inserting a tool around its circumference.

16. Cathode assembly according to Claim 4, further **characterised in that** the tensioning ring (18) is equipped with bores (18b) around its circumference, into which the support bodies (48) for the stationary support of the dark chamber shield (27) are inserted on the rotatable tensioning ring (18).

17. Cathode assembly according to Claim 1, further **characterised in that**
a) a first driven pipe takes the form of a support shaft (6), which ends in the vacuum chamber, and at the end of which a coaxial distancer (67) consisting of an annular flange (62), a hub (63), and a pressure piece (64) is supported;
b) the hub (63) comprises a semi-annular recess for the complimentary pressure piece (64), and **in that** this pressure piece (64) can be rotation resistantly tensioned against the support shaft (6) by means of force closure;
c) the hub (63) is connected with an annular flange (62), supporting at least one arresting lug (70) for engaging an annual sector (71) of an axially following tensioning ring (68) along its circumference;
d) the tensioning ring (68) comprises the at least one annular sector (71) for straddling the arresting lug (70) by means of form closure along its circumference; and **in that**
e) the target pipe (12) comprises an annular flange (69) projecting radially towards the outside, which can be tensioned between the annular flange (62) and the tensioning ring (68) when the two are connected, for rotating the target pipe (12).

18. Cathode assembly according to Claim 17, further **characterised in that** the tensioning ring (68) enclosing the target pipe (12) comprises at least one fork (72) with a tangentially aligned gap (73) along its circumference, into which an arresting pin (18) rotatably affixed to the annular flange (62) can be inserted.

19. Cathode assembly according to Claim 18, further **characterised in that** the annular flange (62) comprises at least one projection (74) with a screw hole (75) along its circumference, into which a tensioning screw (76) can be screwed together with an interim ring (77), and **in that** the arresting pin (78) extends radial in relation to the tensioning screw (76), but tangential in relation to the circumference of the annular flange (62).

## Revendications

1. Dispositif de cathode pour la pulvérisation d'une cible tubulaire (12), comportant un système magnétique (23) non rotatif destiné à générer un champ magnétique destiné à entourer un plasma, la cible tubulaire (12) à l'intérieur d'une chambre sous vide étant apte à tourner à travers le champ magnétique, un arbre porteur (6), apte à être actionné, pour la cible tubulaire (12) étant agencé dans au moins une structure de support (1), un support pour le système magnétique (23) étant agencé en outre à l'intérieur de la cible tubulaire (12), et au moins un dispositif d'accouplement amovible pour le remplacement de la cible tubulaire (12) étant agencé entre l'arbre porteur (6) et la cible tubulaire (12),
**caractérisé en ce qu'**au moins entre l'arbre porteur (6) apte à être actionné et la cible tubulaire (12) sont agencés une pièce intercalaire (15, 67), coaxiale à ceux-ci, et deux zones de séparation (32/53) et (60/61) amovibles et **en ce que** les zones de séparation (32/53) et (60/61) permettent de désolidariser et de réaliser à nouveau les assemblages solidaires en rotation et stables en forme entre l'arbre porteur (6) et la pièce intercalaire (15, 67), d'une part, et la pièce intercalaire (15, 67) et une cible tubulaire (12), d'autre parts; et **en ce qu'** à l'intérieur de l'arbre porteur (6) est agencée une première conduite tubulaire (20), à l'intérieur de la pièce intercalaire (15) est agencée une deuxième conduite tubulaire (21) et à l'intérieur de la cible tubulaire (12) est agencée une troisième conduite tubulaire (22) pour maintenir le système magnétique (23), la première et la deuxième conduite tubulaire (20, 21) étant reliées entre elles par un assemblage enfiché (34) amovible, mais immobile en rotation.

2. Dispositif de cathode selon la revendication 1, **caractérisé en outre en ce que** la première zone de séparation (32) est agencée entre une collerette annulaire (8) sur l'arbre porteur (6) et la pièce intercalaire (15), et la deuxième zone de séparation (53) est agencée entre la pièce intercalaire (15) et la face intérieure de la cible tubulaire (12).

3. Dispositif de cathode selon la revendication 1, **caractérisé en outre en ce que**
a) l'arbre porteur (6) à l'intérieur de la chambre sous vide est muni d'une collerette annulaire (8) avec un premier élément d'emboîtement (11),
b) la pièce intercalaire (15), entre la collerette annulaire (8) et la cible tubulaire (12), est entourée par une première bague de serrage (16) d'un seul tenant et munie d'un deuxième élément d'emboîtement (17), par lequel la pièce intercalaire (15) peut être bloquée coaxialement et de manière immobile en rotation contre la collerette annulaire (8) de l'arbre porteur (6).

4. Dispositif de cathode selon la revendication 1, **caractérisé en outre en ce que** la pièce intercalaire (15) est entourée par une deuxième bague de serrage (18) d'un seul tenant, qui, dans le sens opposé à la première bague de serrage (16), peut être amenée à agir sur des mâchoires d'écartement (36a), mobiles dans le sens radial, d'un dispositif d'écartement (36), par lequel l'extrémité correspondante de la cible tubulaire (12) peut être bloquée coaxialement et de manière immobile en rotation avec la pièce intercalaire (15).

5. Dispositif de cathode selon la revendication 1, **caractérisé en outre en ce que** le premier élément d'emboîtement (11) est réalisé sous la forme d'une fente annulaire coaxiale dans la collerette annulaire (8), et le deuxième élément d'emboîtement (17) est réalisé sur le pourtour extérieur de la collerette annulaire (8).

6. Dispositif de cathode selon la revendication 1, **caractérisé en outre en ce que** la collerette annulaire (8) de l'arbre porteur (6) comporte un évidement coaxial pour l'introduction axiale et par emboîtement radial d'une saillie annulaire (15b) coaxiale et en forme d'anneau, réalisée sur l'extrémité de la pièce intercalaire (15) éloignée de la cible.

7. Dispositif de cathode selon la revendication 6, **caractérisé en outre en ce que** la pièce intercalaire (15) comporte une collerette annulaire (15a) en saillie vers l'extérieur, sur laquelle est réalisée la saillie annulaire (15b).

8. Dispositif de cathode selon la revendication 7, **caractérisé en outre en ce que** la pièce intercalaire (15), sur son côté détourné de la collerette annulaire (15a), comporte une surface de butée (15h) annulaire pour la première bague de serrage (16).

9. Dispositif de cathode selon la revendication 1, **caractérisé en outre en ce que** la pièce intercalaire (15), sur son côté orienté vers la cible tubulaire (12), comporte un filetage extérieur (15f) pour la deuxième bague de serrage (18), par lequel un dispositif d'écartement (36) radial peut être bloqué contre une face intérieure de la cible tubulaire (12).

10. Dispositif de cathode selon la revendication 9, **caractérisé en outre en ce que** le dispositif d'écartement (36) radial comporte au moins trois mâchoires d'écartement (36a) en forme de secteurs avec des surfaces intérieures tronconiques.

11. Dispositif de cathode selon la revendication 9, **caractérisé en outre en ce que** les secteurs des mâchoires d'écartement (36a) sont maintenus aptes à être tirés l'un vers l'autre par un anneau ressort (37) extérieur.

12. Dispositif de cathode selon au moins l'une des revendications 8 à 10, **caractérisé en outre en ce qu'**entre la deuxième bague de serrage (18) et le dispositif d'écartement (36) est agencée une bague de pression (35) qui comporte une surface tronconique (35a) extérieure au moins largement complémentaire aux surfaces tronconiques des mâchoires d'écartement (36a).

13. Dispositif de cathode selon la revendication 1, **caractérisé en outre en ce que** la première bague de serrage (8) pour l'assemblage de la pièce intercalaire (15) avec l'arbre porteur (6) comporte, sur le côté orienté vers la cible tubulaire (12), un évidement annulaire formant un élément d'emboîtement (11) pour la collerette annulaire (15a) de la pièce intercalaire (15).

14. Dispositif de cathode selon au moins une des revendications 1 à 4, **caractérisé en outre en ce que** les deux bagues de serrage (16, 18) sont entourées par un écran de chambre noire (27).

15. Dispositif de cathode selon au moins une des revendications 1 à 4, **caractérisé en outre en ce qu'**au moins la bague de serrage (18) comporte sur sa périphérie des forures (18a) pour l'enfichage d'un outil.

16. Dispositif de cathode selon la revendication 4, **caractérisé en outre en ce que** la bague de serrage (18) comporte sur sa périphérie des forures (18b) dans lesquelles sont enfichés des corps de support (48) pour le support stationnaire de l'écran de chambre noire (27) sur la bague de serrage (18) rotative.

17. Dispositif de cathode selon la revendication 1, **caractérisé en outre en ce que**
a) un premier tube actionné est réalisé sous forme d'arbre porteur (6) qui se termine dans la chambre sous vide, et porte au niveau de cette extrémité une pièce intercalaire (67) coaxiale, formée par une collerette annulaire (62), un moyeu (63) et un élément de pression (64),
b) le moyeu (63) comporte un évidement semi-sphérique pour l'élément de pression (64) complémentaire à celui-ci, et ledit élément de pression (64) peut être bloqué par force et de manière immobile en rotation contre l'arbre porteur (6),
c) le moyeu (63) est assemblé à une collerette annulaire (62) qui porte sur sa périphérie au moins un ergot de blocage (70) destiné à s'engager dans un secteur annulaire (71) d'une bague de serrage (68) axialement consécutive,
d) la bague de serrage (68) comporte sur son pourtour ledit au moins un secteur annulaire (71) destiné à s'engager par emboîtement au-dessus de l'ergot de blocage (70), et **en ce que**
e) la cible tubulaire (12) comporte une collerette annulaire (69) en saillie radiale vers l'extérieur, laquelle, lors de l'assemblage de la collerette annulaire (62) et de la bague de serrage (68), peut être bloquée entre celles-ci pour entraîner en rotation la cible tubulaire (12).

18. Dispositif de cathode selon la revendication 17, **caractérisé en outre en ce que** la bague de serrage (68), entourant la cible tubulaire (12), comporte sur son pourtour au moins un élément fourchu (72) avec une fente (73), qui est orientée tangentiellement et dans laquelle peut être introduit un téton d'arrêt (18), fixé rotatif contre la collerette annulaire (62).

19. Dispositif de cathode selon la revendication 18, **caractérisé en outre en ce que** la collerette annulaire (62) comporte sur son pourtour au moins une saillie (74) avec un trou taraudé (75), dans lequel peut être vissée une vis de serrage (76) en y intercalant une bague (77), et **en ce que** le téton d'arrêt (78) s'étend dans le sens radial par rapport à la vis de serrage (76), mais tangentiellement par rapport au pourtour de la collerette annulaire (62).
